# EUROPEAN PATENT APPLICATION

(11) **EP 2 343 957 A1**
(43) Date of publication of application: **13.07.2011**
(21) Application number: 10150068.4
(22) Date of filing: 04.01.2010
(51) Int. Cl.: H05K 3/32, H05K 3/40

(54) **Electrical interconnect**

(71) Applicant: RESEARCH IN MOTION LIMITED, Waterloo, Ontario N2L 3W8 (CA)
(72) Inventor: Edeler, Wolfgang, 44799 Bochum (DE); Thrien, Markus, 44799 Bochum (DE)
(74) Representative: MERH-IP Matias Erny Reichl Hoffmann

(57) **Abstract**

There is provided an electrical interconnect. The electrical interconnect is assembled by providing at least two elongated metallic strips, and joining each one of the at least two elongated metallic strips to an operative surface of an insulating layer. The electrical interconnect is provided for electrically connecting two electrical circuits. In n this respect, an electrical assembly is also provided including the electrical interconnect and first and second electrical circuits. The first and second electrical circuits are electrically connected by the electrical interconnect.

## Description

### TECHNICAL FIELD

The present disclosure relates to electrical interconnects for connecting electrical circuits.

### BACKGROUND

Electrical interconnects are available for connecting electrical circuits. However, amongst other things, existing electrical interconnects do not provide for the combination of a sufficiently low impedance with a desirably low profile.

### SUMMARY

In one implementation, there is provided an electrical interconnect comprising: a pair of insulating layers, and at least two elongated steel strips disposed between the insulating layers, wherein each one of the at least two elongated steel strips further comprises a maximum thickness of less than 0.3 millimetres.

In another implementation, there is provided an electrical interconnect comprising a pair of insulating layers, and at least two elongated metallic strips disposed between the insulating layers. For at least one of the at least two elongated metallic strips, the elongated metallic strip further comprises an end portion defining a spring contact.

In another implementation, there is provided an electrical interconnect assembled in accordance with the following process: providing at least two elongated metallic strips, and securing each one of the at least two elongated metallic strips between a pair of insulating layers.

In another implementation, there is provided an electrical assembly comprising an electrical interconnect and first and second electrical components. The electrical interconnect further comprises a pair of insulating layers, and at least two elongated steel strips disposed between the insulating layers, wherein each one of the at least two elongated steel strips further comprises a maximum thickness of less than 0.3 millimetres. The first and second electrical components are electrically coupled to one another by the at least two metal strips of the electrical interconnect.

In another implementation, there is provided an electrical assembly comprising an electrical interconnect and first and second electrical components. The electrical interconnect further comprises a pair of insulating layers and at least two elongated metallic strips disposed between the insulating layers, wherein, for at least one of the at least two elongated metallic strips, the elongated metallic strip further comprises an end portion defining a spring contact. The first and second electrical components are electrically coupled to one another by the at least two elongated metallic strips of the electrical interconnect.

In another implementation, there is provided an electrical assembly comprising an electrical interconnect and first and second electrical components. The electrical interconnect is assembled in accordance with the following process: providing at least two elongated metallic strips, and securing each one of the at least two elongated metallic strips between a pair of insulating layers. The first and second electrical components electrically coupled to one another by the at least two elongated metallic strips of the electrical interconnect.

### BRIEF DESCRIPTION OF DRAWINGS

The implementations will be described with reference to the following drawings, in which:
Figure 1 is a top perspective view of one side of a first insulating layer of an electrical interconnect;
Figure 2 is a top perspective view of a pair of metallic strips joined to one side of a second insulating layer of the electrical interconnect;
Figure 3 is a bottom perspective view of an opposite side of the second insulating layer of the electrical interconnect; and

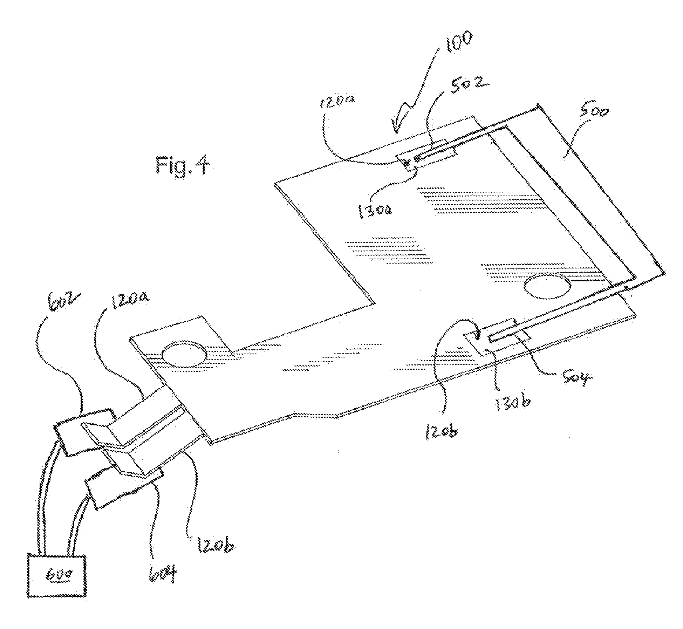

Figure 4 is a schematic illustration of an electrical circuit which incorporates the electrical interconnect.

### DETAILED DESCRIPTION

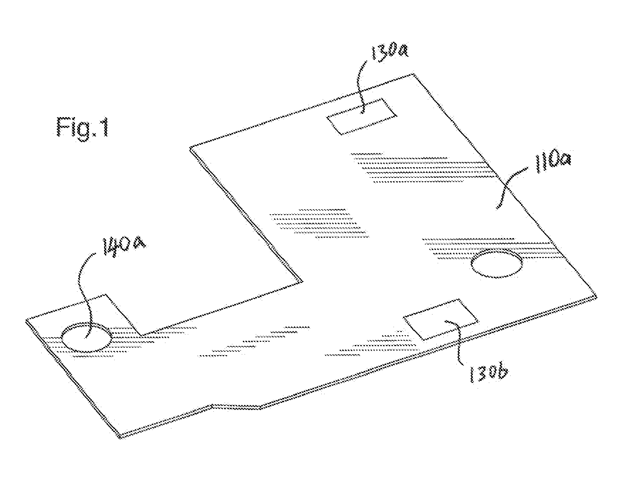

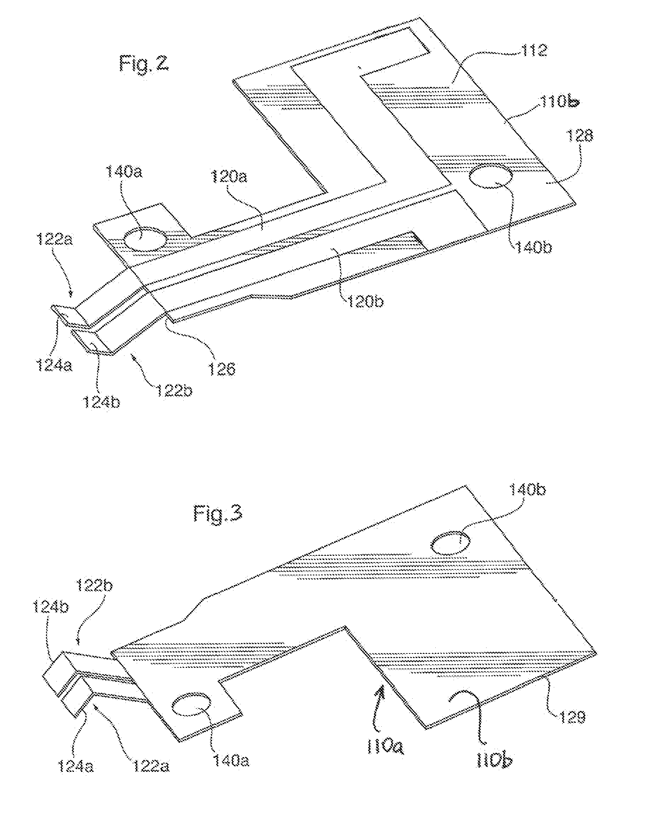

Referring to Figures 1 and 2, there is provided an electrical interconnect 100. The electrical interconnect 100 includes first and second insulating layers 110a, 110b and at least two elongated metallic strips 120a, 120b disposed between and coupled to the layers 110a, 110b. Amongst other things, the provided electrical interconnect 100 provides a low profile and also provides for low impedance.

For example, in some implementations, each one of the insulating layers 110a, 110b is flexible.

For example, in some implementations, either one of the insulating layers 110a, 110b is made from Kapton™ polyimide film or other suitable material which provides an isolation functionality similar to polycarbonate or polyethylene terephthalate isolation sheet material.

For example, in some implementations, guiding holes 140a, 140b are provided in each one of the insulating layers 110a, 110b for desired positioning on substrates which are being electrically connected.

The electrical interconnect 100 is configured to electrically connect the terminal of a first electrical circuit with the terminal of a second electrical circuit. For example, the electrical interconnect 100 includes ports 130a, 130b in the insulating layer 110a of the electrical interconnect 100 for facilitating electrical connection between the metallic strips 120a, 120b and an electrical circuit.

In this respect, there is also provided an electrical assembly 200 including the electrical interconnect 100 and the first and the second electrical circuits. The first electrical circuit is electrically coupled to the second electrical circuit by the electrical interconnect 100.

For example, with respect to each of the first and the second electrical circuits, each one of the first and the second electrical circuits is provided as at least a portion of any one of a printed circuit board or a transducer.

For example, and referring to Figure 3, one of the first and second electrical circuits is an electrical circuit incorporated within a speaker 500. In this respect, the speaker 500 includes speaker spring contacts 502, 504. Each one of the speaker spring contacts 502, 504 is configured for contacting a respective one of the metallic strips 120a, 120b by extending through a respective one of the ports 130a, 130b. The other electrical circuit is incorporated within an amplifier 600. The amplifier 600 includes amplifier electrical contacts 602, 604 which are configured to contact an end portion 122a (or 122b) of a respective one of the metallic strips 120a, 120b.

### First Implementation

In one implementation, the electrical interconnect 100 includes insulating layers 110a, 110b and at least two elongated steel strips 120a, 120b disposed between each one of the insulating layers 110a, 110b. For example, each one of the at least two elongated steel strips 120a, 120b is coupled (for example, adhered) to each one of the insulating layers 110a, 110b. Each one of the at least two elongated steel strips 120, 120b includes a maximum thickness of less than 0.3 millimetres. Each one of the at least two elongated steel strips 120a, 120b defines an electrically conductive trace or line.

In some of these implementations, for example, each one of the at least two elongated steel strips 120a, 120b is obtained as a stamping out of a steel coil or plate.

In some of these implementations, for example, the minimum thickness of each one of the at least two elongated steel strips 120a, 120b is at least 0.05 millimetres.

In some of these implementations, for example, the thickness for each one of the at least two elongated steel strips 120a, 120b is between 0.05 millimetres and 0.3 millimetres.

In some of these implementations, for example, each one of the insulating layers 110a, 110b includes a maximum thickness of less than 0.3 millimetres.

In some of these implementations, for example, each one of the insulating layers 110a, 110b includes a minimum thickness of at least 0.02 millimetres.

In some of these implementations, for example, each one of the insulating layers 110a, 110b includes plastic. Suitable plastics include polycarbonate, polyethylene terephthalate, and acrylonitrile butadiene styrene.

In some of these implementations, for example, an end portion 122a (or 122b) of at least one of the at least two elongated steel strips 120a, 120b defines a spring contact 124a (or 124b). For example, for each one of the at least two elongated steel strips 120a, 120b including an end portion 122a (or 122b) defining a spring contact 124a (or 124b), the end portion 122a (or 122b) defining the spring contact 124a (or 124b) is resilient. For example, for each one of the at least one elongated steel strip including an end portion 122a (or 122b) defining a spring contact 124a (or 124b), the end portion 122a (or 122b) extends beyond the perimeter 126 of each one of the insulating layers 110a, 110b.

For example, suitable steels for these implementations include SUS 302 stainless steel and SUS 304 stainless steel.

### Second Implementation

In another implementation, the electrical interconnect 100 includes insulating layers 110a, 110b and at least two elongated metallic strips 120a, 120b disposed between each one of the insulating layers 110a. 110b. For example, each one of the at least two elongated metallic strips 120a, 120b is coupled (for example, adhered) to each one of the insulating layers 110a, 110b. For at least one of the at least two elongated metallic strips 120a, 120b, the elongated metallic strip 120a (120b) includes an end portion 122a (or 122b) defining a spring contact 124a (or 124b). Each one of the at least two elongated metallic strips 120a, 120b defines an electrically conductive trace or line.

In some of these implementations, for example, each one of the at least two elongated metallic strips 120a, 120b is obtained as a stamping out of a steel coil or plate.

In some of these implementations, for example, for each one of the at least one elongated metallic strip including an end portion 122a (or 122b) defining a spring contact 124a (or 124b), the end portion 122a (or 122b) defining the spring contact 124a (or 124b) is resilient.

In some of these implementations, for example, for each one of the at least one elongated metallic strip including an end portion 122a (or 122b) defining a spring contact 124a (or 124b), the end portion 122a (or 122b) extends beyond the perimeter 126 of each one of the insulating layers 110a, 110b.

In some of these implementations, for example, each one of the at least two elongated metallic strips 120a, 120b includes a maximum thickness of less than 0.3 millimetres.

In some of these implementations, for example, each one of the at least two elongated metallic strips 120a, 120b includes a minimum thickness of at least 0.05 millimetres.

In some of these implementations, for example, the thickness for each one of the at least two elongated metallic strips 120a, 120b is between 0.05 millimetres and 0.3 millimetres.

In some of these implementations, for example, each one of the insulating layers 110a, 110b includes a maximum thickness of less than 0.3 millimetres.

In some of these implementations, for example, each one of the insulating layers 110a, 110b includes a minimum thickness of at least 0.02 millimetres.

In some of these implementations, for example, each one of the insulating layers 110a, 110b includes plastic. Suitable plastics include polycarbonate, polyethylene terephthalate, and acrylonitrile butadiene styrene.

In some of these implementations, for example, each one of the at least two metallic strips 120a, 120b includes any one of copper, steel (such as SUS 302 stainless steel or SUS 304 stainless steel), silver, gold, or any other conductive metal.

### Third Implementation

In another implementation, there is provided a process for assembling an electrical interconnect 100. In this respect, there is also provided an electrical interconnect 100 assembled in accordance with this process. The process includes:
(a) providing at least two elongated metallic strips 120a, 120b;
(b) securing each one of the at least two metal strips 120a, 120b between a pair of insulating layers 110a, 110b.

Each one of the at least two elongated metallic strips 120a, 120b defines an electrically conductive trace or line.

In some of these implementations, for example, each one of the at least two elongated metallic strips 120a, 120b is obtained as a stamping out of a steel coil or plate.

In some of these implementations, for example, the securing is effected by adhesion to one or both of the insulating layers 110, 110b, such as by using two-sided tape (such as two-sided tape supplied by Tesa SE of Hamburg, Germany).

In some of these implementations, for example, each one of the at least two elongated metallic strips 120a, 120b includes a maximum thickness of less than 0.3 millimetres.

In some of these implementations, for example, each one of the at least two elongated metallic strips 120a, 120b includes a minimum thickness of at least 0.05 millimetres.

In some of these implementations, for example, the thickness for each one of the at least two elongated metallic strips 120a, 120b is between 0.05 millimetres and 0.3 millimetres.

In some of these implementations, for example, each one of the insulating layers 110a, 110b includes a maximum thickness of less than 0.3 millimetres.

In some of these implementations, for example, each one of the insulating layers 110a, 110b includes plastic. Suitable plastics include polycarbonate, polyethylene terephthalate, and acrylonitrile butadiene styrene.

In some of these implementations, for example, an end portion 122a (or 122b) of at least one of the at least two elongated metallic strips 120a, 120b defines a spring contact 124a (or 124b). For example, for each one of the at least one elongated metallic strip including an end portion 122a (or 122b) defining a spring contact 124a (or 124b), the end portion 122a (or 122b) defining the spring contact 124a (or 124b) is resilient. For example, for each one of the at least one elongated metallic strip including an end portion 122a (or 122b) defining a spring contact 124a (or 124b), the end portion 122a (or 122b) extends beyond the perimeter 126 of each one of the insulating layers 110a, 110b.

In some of these implementations, for example, each one of the at least two metallic strips 120a, 120b includes any one of copper, steel (such as SUS 302 stainless steel or SUS 304 stainless steel), silver, gold, or any other conductive metal.

In the above description, for purposes of explanation, numerous details are set forth in order to provide a thorough understanding of the present disclosure. However, it will be apparent to one skilled in the art that these specific details are not required in order to practice the present disclosure. In other instances, well-known electrical structures and circuits are shown in block diagram form in order not to obscure the present disclosure. Although certain dimensions and materials are described for implementing the disclosed example implementation, other suitable dimensions and/or materials may be used within the scope of this disclosure. All such modifications and variations, including all suitable current and future changes in technology, are believed to be within the sphere and scope of the present disclosure. All references mentioned are hereby incorporated by reference in their entirety.

## Claims

1. An electrical interconnect (100) comprising:
a pair of insulating layers (110a, 110b); and
at least two elongated steel strips (120a, 120b) disposed between the insulating layers (110a, 110b);
wherein each one of the at least two elongated steel strips (120a, 120b) further comprises a maximum thickness of less than 0.3 millimetres.

2. The electrical interconnect (100) as claimed in claim 1,
wherein each one of the insulating layers (110a, 110b) further comprises a maximum thickness of less than 0.3 millimetres.

3. The electrical interconnect (100) as claimed in claim 1 or 2,
wherein each one of the insulating layers (110a, 110b) further comprises plastic.

4. The electrical interconnect (100) as claimed in any preceding claim,
wherein an end portion (122a or 122b) of at least one of the at least two elongated steel strips (120a, 120b) defines a spring contact.

5. The electrical interconnect (100) as claimed in claim 4,
wherein, for each one of the at least one elongated steel strip (120a, 120b) further comprising an end portion (122a or 122b) defining a spring contact, the end portion defining the spring contact is resilient.

6. The electrical interconnect (100) as claimed in claim 4,
wherein, for each one of the at least one elongated steel strip (120a, 120b) further comprising an end portion (122a or 122b) defining a spring contact, the end portion extends beyond the perimeter of the insulating layer (110a or 110b).

7. An electrical interconnect (100) comprising:
a pair of insulating layers (110a, 110b); and
at least two elongated metallic strips (120a, 120b) disposed between the insulating layers (110a, 110b);
wherein, for at least one of the at least two elongated metallic strips (120a or
120b), the elongated metallic strip (120a or 120b) further comprises an end portion (122a or 122b) defining a spring contact.

8. The electrical interconnect (100) as claimed in claim 7,
wherein, for each one of the at least one elongated metallic strip (120a or 120b) further comprising an end portion (122a or 122b) defining a spring contact, the end portion (122a or 122b) defining the spring contact is resilient.

9. The electrical interconnect (100) as claimed in claim 7 or 8,
wherein, for each one of the at least one elongated metallic strip (120a or 120b) further comprising an end portion (122a or 122b) defining a spring contact, the end portion (122a or 122b) extends beyond the perimeter of the insulating layer.

10. The electrical interconnect (100) as claimed in any of claims 7 to 9,
wherein each one of the insulating layers (110a, 110b) further comprises a maximum thickness of less than 0.3 millimetres.

11. The electrical interconnect (100) as claimed in any of claims 7 to 10,
wherein each one of the insulating layers (110a, 110b) further comprises plastic.

12. The electrical interconnect (100) as claimed in any of claims 7 to 11, wherein each one of the at least two metallic strips (120a or 120b) further comprises any conductive metal.

13. An electrical interconnect (100) assembled in accordance with the following process:
providing at least two elongated metallic strips (120a or 120b); and
securing each one of the at least two elongated metallic strips between a pair of insulating layers (110a, 110b).

14. The electrical interconnect (100) as claimed in claim 13, wherein the securing is effected by adhesion.

15. The electrical interconnect (100) as claimed in claim 13 or 14,
wherein each one of the at least two elongated metallic strips (120a or 120b) further comprises a maximum thickness of less than 0.3 millimetres.

16. The electrical interconnect (100) as claimed in any of claims 13 to 15,
wherein each one of the insulating layers (110a, 110b) further comprises a maximum thickness of less than 0.3 millimetres.

17. The electrical interconnect (100) as claimed in any of claims 13 to 16,
wherein each one of the insulating layers (110a,110b) further comprises plastic.

18. The electrical interconnect (100) as claimed in any of claims 13 to 17,
wherein an end portion (122a or 122b) of at least one of the at least two elongated metallic strips defines a spring contact.

19. The electrical interconnect (100) as claimed in claim 18,
wherein, for each one of the at least one elongated metallic strip (120a or 120b) further comprising an end portion (122a or 122b) defining a spring contact, the end portion defining the spring contact is resilient.

20. The electrical interconnect (100) as claimed in claim 18,
wherein, for each one of the at least one elongated metallic strip (120a or 120b) further comprising an end portion (122a or 122b) defining a spring contact, the end portion (122a or 122b) extends beyond the perimeter of the insulating layer (110a or 110b).

21. The electrical interconnect (100) as claimed in claim 13, wherein each one of the at least two metallic strips (120a or 120b) further comprises any conductive metal.

22. An electrical assembly (200) comprising:
an electrical interconnect (100) further comprising:
a pair of insulating layers (110a, 110b); and
at least two elongated steel strips (120a, 120b) disposed between the insulating layers (110a, 110b);
wherein each one of the at least two elongated steel strips (120a, 120b) further comprises a maximum thickness of less than 0.3 millimetres; and
first and second electrical components (500, 600) electrically coupled to one another by the at least two metal strips (110a or 110b) of the electrical interconnect (100).

23. The electrical assembly (200) as claimed in claim 22, wherein each one of the first and second electrical components (500, 600) is any one of: a transducer and a printed circuit board.

24. An electrical assembly (200) comprising:
an electrical interconnect (100) further comprising:
a pair of insulating layers (110a, 110b); and
at least two elongated metallic strips (120a or 120b) disposed between the insulating layers (110a, 110b);
wherein, for at least one of the at least two elongated metallic strips (120a or 120b), the elongated metallic strip (120a or 120b) further comprises an end portion (122a or 122b) defining a spring contact; and
first and second electrical components (500, 600)electrically coupled to one another by the at least two elongated metallic strips (120a or 120b) of the electrical interconnect (100).

25. An electrical assembly (200) comprising:
an electrical interconnect (100) assembled in accordance with the following process:
providing at least two elongated metallic strips (120a or 120b); and
securing each one of the at least two elongated metallic strips (120a or 120b) between a pair of insulating layers (110a, 110b); and
first and second electrical components (500, 600) electrically coupled to one another by the at least two elongated metallic strips (120a or 120b) of the electrical interconnect (100).
